(19) Europäisches Patentamt
European Patent Office
Office européen des brevets

(11) **EP 4 749 885 A1**

(12) **EUROPEAN PATENT APPLICATION**

(43) Date of publication:
**27.05.2026 Bulletin 2026/22**

(21) Application number: **25216387.8**

(22) Date of filing: **17.11.2025**

(51) International Patent Classification (IPC):
**H02J 7/80** (2026.01)     **G01R 31/367** (2019.01)
**G01R 31/392** (2019.01)     **G06N 3/08** (2023.01)
**G06N 20/00** (2019.01)

(52) Cooperative Patent Classification (CPC):
**H02J 7/80; G01R 31/367; G06N 3/044;
G06N 3/045; G06N 3/047; G06N 3/08; G06N 3/088;
G06N 7/01; G06N 20/00;** G01R 31/392

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.11.2024 IN 202411090984**

(71) Applicant: Honeywell International Inc.
**Charlotte, NC 28202 (US)**

(72) Inventors:
• **CARPENTER, Deepak Kumar
Charlotte 28202 (US)**

• **SHARMA, Divyanshu
Charlotte 28202 (US)**
• **GANDHI, Ketan
Charlotte 28202 (US)**
• **ALABUR, Manjunatha
Charlotte 28202 (US)**
• **PADMANABHAPILLAI, Sreenath Krishnapillai
Charlotte 28202 (US)**

(74) Representative: **Haseltine Lake Kempner LLP
Cheapside House
138 Cheapside
London EC2V 6BJ (GB)**

(54) **METHODS FOR AUTONOMOUSLY MONITORING AND ANALYZING THE OPERATION OF A BATTERY ENERGY STORAGE SYSTEM**

(57) A method for monitoring and analyzing the operation of a battery energy storage system (BESS) comprises, entering data parameters from one or more subsystems of a field installed BESS into a correlation matrix and extracting target correlations from the correlation matrix. The target correlations along with independent data parameters are entered into a relational coefficient matrix to identify data features. The method further includes extracting the data features from the relational coefficient matrix to a generative and adversarial artificial intelligence network model, where the extracted data features are used to train the model with data from the field installed BESS solution.

FIG. 1

## Description

TECHNICAL FIELD

This disclosure is generally directed to battery energy storage systems (BESS). More specifically, it relates to methods that use a multi-model system architecture and a coefficient of the correlation between BESS subsystems with generative artificial intelligent networks and machine learning approaches to generate real-world data for autonomously monitoring and analyzing the operation of a BESS.

BACKGROUND

Currently, most electric power is generated by large, centralized power plants, such as nuclear power plants, hydroelectric plants, and fossil fuel powered plants. These large facilities frequently generate power using non-renewable sources of energy, such as coal or gas. Such power plants commonly have good economies of scale, however due to various economic and operational reasons may not provide all the power required to service the loads of the electrical grid services by the centralized power plant. Battery energy storage systems (BESS) having stored power may be connected at a power plant, substation, transmission line or at a customer site to selectively use stored battery energy to supplement or provide all the power required by the grid and prevent service interruptions. A BESS may employ chemical energy storage batteries that chemically store energy such as for example lithium iron (Li-ON) batteries, lead acid batteries (Pb), or sodium-sulfur (NAS) batteries.

Due to the interrelated nature of the components comprising a BESS, any reliable data model of a BESS requires a close-to real-world data set as input to consider the components comprising a BESS and their influences on each other. The accuracy of the data set allows for a more correct analysis when fault insertions are made to a BESS to understand what impact the faults may have on the operation of a BESS. Faults in a BESS subsystem may disrupt normal operation of the BESS during charging or discharging and pose potential hazards to human safety.

SUMMARY

This disclosure relates to methods that use generative artificial intelligence and machine learning to generate real-world multi-model data sets. The generated data sets use a coefficient of correlation matrix between the subsystems comprising a BESS for the purpose of monitoring, analyzing, and comparing the behavior of the BESS operation to predict early failure.

In a first embodiment a method for generating real-world data for autonomously monitoring and analyzing the operation of a battery energy storage system (BESS) is disclosed, the method comprises, entering data parameters from one or more subsystems of a field installed BESS into a correlation matrix and extracting a target correlation from the correlation matrix. Entering the target correlation and independent data parameters into a relational coefficient matrix to identify data features. The method further includes extracting the data features from the relational coefficient matrix to a generative and adversarial artificial intelligence network model, wherein the extracted data features are used to train the model with data from the field installed BESS solution to monitor and analyze the operation of the BESS.

In a second embodiment a multi-model method for monitoring and analyzing the operation of a battery energy storage system (BESS) is disclosed. The multi-model method comprises, providing a plurality of models that simulate the operation of the BESS and entering dependent data parameters from one or more subsystems of a field installed BESS into a correlation matrix. Extracting at least one target correlation from the correlation matrix and entering the target correlation and independent data parameters into a respective one relational coefficient matrix for each of a plurality of models to identify data features. The method further includes extracting the data features from each respective relational coefficient matrix to a respective one generative and adversarial artificial intelligence network model, wherein the extracted data features are used to train each model with data from the field installed BESS solution to monitor and analyze the operation of the BESS.

Other technical features may be readily apparent to one skilled in the art from the following figures, descriptions, and claims.

BRIEF DESCRIPTION OF THE DRAWINGS

For a more complete understanding of this disclosure, reference is now made to the following description, taken in conjunction with the accompanying drawings, in which:

FIG. 1 is a diagram schematically illustrating a BESS container;

FIG. 2 is a table illustrating a relational coefficient matrix according to the present disclosure;

FIG. 3 is diagram schematically illustrating an exemplary BESS model according to the present disclosure;

FIG. 4 is a block diagram of an exemplary first embodiment of a method for collecting and extracting features from a BESS solution for the purposes of training BESS models according to the present disclosure;

FIG. 5 is a block diagram of an exemplary second embodiment of a method for collecting and extracting features from a BESS solution which includes calibration and anomaly/fault parameters as additional features for training the BESS models according to the present disclosure;

FIG. 6 is diagram schematically illustrating an exemplary common model architecture for a BESS according to the present disclosure; and

FIG. 7 is a diagram schematically illustrating an exemplary calibration and anomaly/fault model architecture for a BESS according to the present disclosure.

DETAILED DESCRIPTION

The figures discussed below, and the various embodiments used to describe the principles of the present invention in this patent document are by way of illustration only and should not be construed in any way to limit the scope of the invention. Those skilled in the art will understand that the principles of the invention may be implemented in any type of suitably arranged device or system.

A reliable and accurate model of the operation of a BESS solution requires a close-to real-world data set as input due to a BESS inter-relationship with and their influences on each other. In a BESS solution, the seamless integration and operation of various subsystems are imperative for optimal performance. These subsystems include critical components and equipment such as the Battery Management System (BMS), Power Conversion System (PCS), Energy Control System (ECS), HVAC, and inflammable gas sensors, among others.

The operational factors that affect timely and accurate data collection, such as, for example, safe shutdown and unsafe equipment scenarios must be accurately input into the model. The reliability and safety of a BESS solution depends on the continuous acquisition of accurate data within predefined time frames during its round-trip cycle. Any deviation or malfunction within these subsystems could not only disrupt the normal operation of the BESS during charging or discharging but also pose potential hazards to human safety. Given the interconnected nature of the BESS solution, the safety protocol heavily relies on the integrity of data received from the subsystem components and equipment. The prospect of receiving unexpected data introduces the risk of triggering safety-related trips or generating false readings. A BESS response time of 175ms to 325ms without measurement feedback, and 450ms to 715ms with feedback, is essential for the secure operation of the critical components of the BESS described above.

Safety protocols require that a BESS solution incorporate robust measures for the safe shutdown procedures in the event of equipment sensor malfunctions or faults. Should a sensor malfunction be detected, the system is designed to initiate an immediate trip and isolate the affected components. Similarly, in the case of a faulty sensor, the BESS will promptly trigger a trip and isolate the respective sensor. These fail-safe mechanisms are crucial in averting potential risks and ensuring the overall safety of operations during charging or discharging cycles. By quickly identifying and addressing sensor irregularities, the BESS solution aims to safeguard both component integrity and more importantly, human safety.

An unsafe scenario may arise if equipment sensor malfunctions or is faulty yet fails to initiate the necessary trip or isolate the component or equipment. This scenario poses risk, as the compromised sensor data could potentially lead to erroneous readings or unsafe conditions during the BESS operation. To mitigate this risk, the BESS solution prioritizes the immediate identification of sensor malfunctions and faults, aiming to prevent any lapses in the safety protocol. The implementation of fail-operational mechanisms ensures that, even in the presence of sensor anomalies, the system responds promptly by initiating a trip and isolating the equipment to avoid adverse consequences.

The method of the present disclosure describes an example of a generative artificial intelligence and machine learning approach to generating real-world data for the subsystems comprising a BESS solution using relational matrix models. The methods described herein may be applied to monitor and analyze a BESS solution deployed in the field or in a laboratory to simulate the behavior of a BESS solution before it is commissioned and operationally deployed.

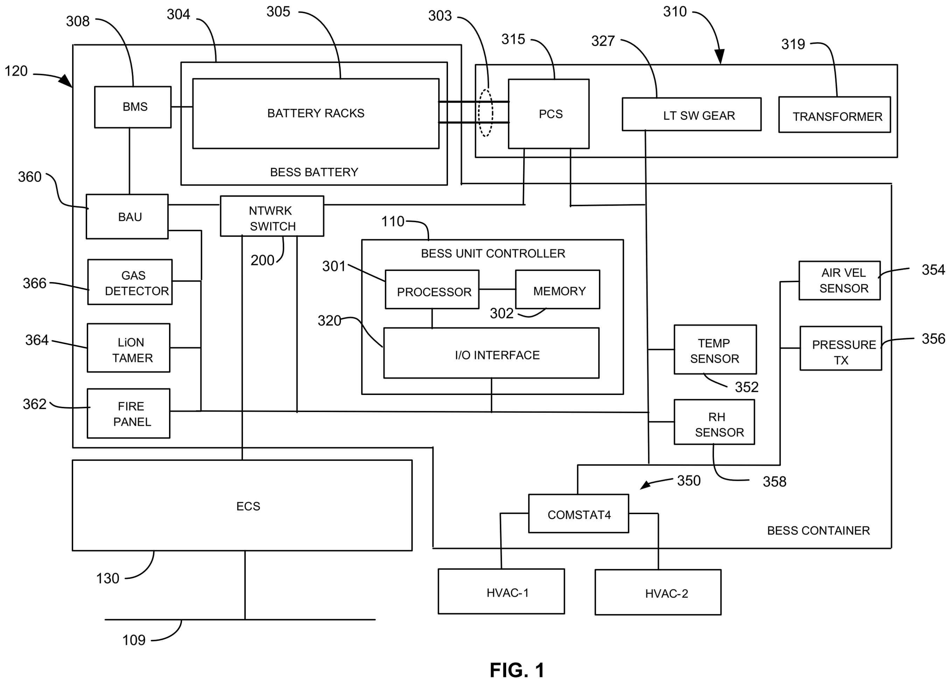

FIG. 1 illustrates an exemplary BESS solution that includes a self-contained container 120 and that may at least include a storage battery 304, a BMS subsystem 308 and a heating ventilation, and air conditioning (HVAC) subsystem 350. A separate power container 310 includes a power conversion subsystem (PCS) 315. An electronic control subsystem (ECS) 130 is shown separate from the BESS container 120, however, in certain BESS deployments the ECS 130 may be contained within the BESS container. The BESS container 120 may also house sensors required to monitor the BESS container 120, such as for example, a gas detector 366, temperature and relative humidity sensors 352 and 358. Each BESS container 120 can be used to power stand-alone deployments of a BESS solution such as, for example, a building or a business enterprise or microgrid deployments where a single BESS container 120 or multiple BESS containers 120 can provide power to a neighborhood of homes or to a business district.

A BESS unit controller 110 is tasked to provide for the safe and reliable operation of a BESS container 120. The BESS unit controller 110 monitors the operation of the BESS container 120 preventing operations during fault conditions, shutting down a faulty subsystem and/or sending notifications and alarms to operator station 164 or to mobile device 240. Alarms may be sent using different priority levels if a component, sensor, or subsystem of the BESS unit container 120 fails or becomes faulty. The BESS unit controller 110 interfaces with all the subsystems within a container such as the PCS 315, the storage battery 304 the HVAC subsystems 350, and/or any fire protection systems etc.

The BESS unit controller 110 is comprised of at least one processor 301, at least one memory device 302, and at least one I/O interface 320. The processor 301 executes instructions that may be loaded into memory 302. Processor 301 may include any suitable number(s) and type(s) of processing or other devices in any suitable arrangement. Example types of processing devices include microprocessors, microcontrollers, digital signal processors, field programmable gate arrays, application specific integrated circuits, and discreet circuitry. Processor 301 executes the various programs that operate the various operating modes, states, and safety systems of the BESS container 120.

Memory 302 represents any structure(s) capable of storing and facilitating retrieval of information (such as data, program code, and/or other suitable information on a temporary or permanent basis). Memory 302 may represent a random-access memory or any other suitable volatile or non-volatile storage device(s). The memory may also include one or more components or devices supporting longer-term storage of data, such as a ready only memory, hard drive, flash memory, or optical disc.

The I/O interface 320 supports communications with the other systems or devices contained in the BESS container 120. For example, the communications interface 320 could include I/O modules and a network interface card that facilitates communications between the BESS unit controller 110 and the subsystems and sensors of the BESS container 120. The I/O interface 320 may support communications through any suitable physical wired communication link or bus. For example, the I/O interface 320 may include an I/O module that can interface control signals to connected HVAC units HVAC-1 and HVAC-2 through a comstat4 HVAC controller using a serial digital output. The I/O interface 320 may also include an analog module that can receive 4-20 mAh current loop signals from the various analog sensors located in the BESS container 120, such as for example, temperature sensor 352, air velocity sensor 354, pressure sensor and transmitter 356 and the relative humidity (RH) sensor 358. The I/O interface 320 also includes an Ethernet interface for bidirectional communication of control signals and data between a battery administration unit (BAU) 360, the ECS 130 and the various fire safety devises such as the fire detection panel 362 and LiON-tamer 364 and gas detector 366, that detects hydrogen gas that may be generated by lithium batteries as they degrade.

The BESS container 120 includes a storage battery, hereinafter referred to as a BESS battery 304.

The BESS battery 304 is comprised of multiple battery racks 305 that are electrically interconnected in series and in parallel. Each battery rack comprises a plurality of battery cells organized as battery modules that are also electrically interconnected in series and in parallel. The multiple battery modules that form the multiple battery racks 305 are stacked within the BESS container 120. Charging and discharging of the BESS battery 304 considers the state of charge (SOC) of the battery racks 305 comprising the BESS battery 304 and ensures that charging does not cause increased power dissipation and heating of the cells contained in the battery racks.

Each BESS container 120 is connected to a power container 310 that is electrically coupled to the BESS container 120. The power container 310 typically includes a bidirectional PCS 315, electrical mains 303 and associated electrical switch gear components. The PCS 315 converts an AC voltage supplied by the grid to DC voltage to charge the BESS battery racks 305 using the electrical mains 303. The PCS 315 also converts the DC power provided by the BESS battery racks 305 into an AC voltage, providing electrical power back to the grid, a microgrid or to a connected plant, or building. The power container 310 may also include low tension (LT) switch gear 327 and transformer 319 to provide electrical power to low tension or low voltage electrical networks.

The BESS unit controller 110 is operatively connected to an ECS 130. The ECS 130 acts as a supervisory controller to one or more BESS unit controllers 110. An ECS 130 can control one or more BESS containers 120 using the control network 109. The BESS unit controller 110 of each BESS container 120 gathers the operating parameters of a connected BESS unit 120 and sends the data to its supervising ECS 130 for control of the charging and discharging requirements of the BESS container(s) 120. For example, ECS 130 computes the power reference for each PCS 315 attached to one or more BESS container 120, considering the current operational state of a BESS container 120, such as alarms related to failure of subsystems or faults and diagnostics data of critical subsystems, such as the battery racks 305, PCS 315 and HVAC subsystem 350.

When multiple BESS containers 120 and their power containers 310 are deployed to provide electrical power at a stand-alone site or microgrid, the ECS 130 determines the total charging power or discharging power that should be provided to the deployment and distributes the charging or discharging power requirements to the connected multiple BESS unit controllers 110. For example, ECS 130 computes a power reference for the different PCS 315 units, considering the power capacity of each PCS 315 and the power and energy capacity of the BESS container 120. The power and energy capacity of the BESS container 120 is determined by the number of battery racks 305 in operation. When there are multiple BESS containers 120 deployed at a stand-alone site, or at a microgrid site, and the multiple BESS containers 120 are connected to a single PCS 315, the ECS 130 computes a power reference for all the PCSs 315 available to be connected.

In installations having multiple BESS containers 120 the balancing state of the battery racks 305 for one BESS container 120 with the battery racks of another BESS container is not considered by either the BMS 308 or the battery administration unit (BAU) 360 associated with the BESS container 120. In such multiple BESS installations, the ECS 130 manages each BAU 360 of a BESS container 120 through its respective BESS unit controller 110, via network switch 200. The ECS 130 provides SOC balancing through the BAU 360 to the BMS 308 of each of the battery racks 305 of the multiple connected BESS containers 120.

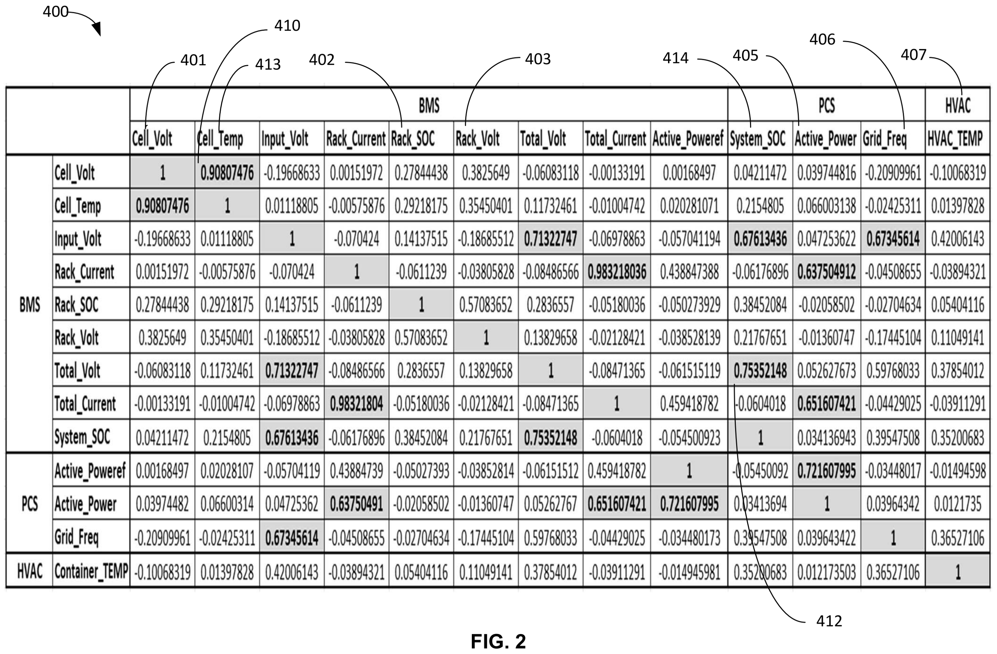

The behavior of the various subsystem parameters of a BESS solution can be put into 2 categories, dependent parameters, and independent parameters. Dependent parameters of a BESS subsystem are either related or depend on the parameter(s) of another subsystem operating in the BESS. Independent parameters do not rely on another BESS subsystem. These parameters from various BESS subsystems are mapped into a relational coefficient matrix 400 shown in FIG. 2.

The correlation matrix 400 presented here is derived from data sets exported from active containerized BESS solutions in the field. The correlation matrix 400 includes parameters from the BESS subsystems such as the BMS 308, the PCS 315 and the HVAC 350 subsystems of a BESS container 120. Data from specific parameters for each subsystem is collected and input to the correlation matrix 400. For example, for the BMS 308 subsystem parameters may include cell voltage (Cell_Volt) 401, rack SOC (Rack_SOC) 402 and rack voltage (Rack_Volt) 403, etc. For the PCS subsystem 315, an active power (Active_Power) 405 and grid frequency (Grid_Freq) 406 parameters are collected and for the HVAC 350 subsystem a BESS container temperature (Container_Temp) 407 is collected.

As shown in FIG. 2 highlighted correlation coefficients reveal a range from moderate to strong correlations among various parameters of the BESS subsystems as is shown in the highlighted cells. For example, there is a robust positive correlation 410 observed between Cell_Volt 401 and cell temperature (Cell_Temp) 413 during charging process. Furthermore, a moderate positive correlation 412 is identified between total system level voltage (Total_Volt) and system-level SOC (System_SOC) 414 during charging, suggesting a non-linear relationship between voltage and SOC. The analysis indicates that at lower and higher levels of SOC, voltage tends to exhibit a slower increase compared to medium SOC levels.

The correlation matrix 400 serves as input to a BESS model architecture for training models used for the multi-model's data generation that simulate various conditions for a real-world BESS operation. Moreover, the matrix 400 itself can be evaluated over time to assess whether correlations are changing or evolving with the aging of the BESS. Such insights contribute to a comprehensive understanding of the interdependencies within the BESS data sets and offer valuable considerations for ongoing model tuning and system evaluation.

The architecture of the BESS model uses a multi-model approach to address the different functionalities and characteristics of a BESS solution. For example, one of the models in the system architecture is a common or factory model that has ideal subsystem behavior where the data from each subsystem includes relational as well as independent parameters that do not degrade in the performance of the BESS. The factory model represents a factory generated BESS system which may or may not have any anomaly in the parameters or its subsystems as indicated in the correlation matrix 400. The factory model represents the ideal behavior of the system.

The generator for the factory model can be represented as:

$$yg = G(z, x),$$

where z = the random noise vector (this noise vector will have the same shape as the real data set) and,

x = input feature.

The discriminator for the factory model can be represented as:

$$D(y) \rightarrow [0,1] \text{ and } D(yg) \rightarrow [0,1]$$

where D(y) = the discriminator's output for the real data set and,

D(yg) = the output for the generated data.

Another model in the BESS architecture is a calibration model. The calibration model represents a model architecture based on BESS subsystem parameters whose behavior deviates from the default factory model. In a real-world operational environment, a BESS solution does not remain the same over a period during its operational life. Some of the parameters, such as for example SOC change due to the aging of battery cells. The aging of battery cells causes a variation in the power that a battery cell can provide. Properly maintained BESS solutions will periodically calibrate the cells contained in the BESS battery to establish the stored energy that the battery cell can provide. The calibration of the cells contained in a BESS battery when performed is added to the correlation matrix 400 and passed to the calibration model architecture as an input. The calibration model is then trained on this added feature. During training, a binary cross entropy loss for the calibration is added for each calibrated parameter. The additional features that represent calibrated parameters are shown below.

The generator for the calibration model can be represented as:

$$yg = G(z,x+f)$$

where z = the random noise vector and

x+f = the combined input features, including original correlations and the additional calibration features.

The discriminator for the calibration model can be represented as:

D(y, x)-> [0,1] and D(yg, x)->[0,1]
where D is discriminator taking both real data y and generated data yg as input and
x = the included additional calibration features.

Another model architecture is an anomaly/fault model. The anomaly/fault model is designed to manage and train a BESS subsystem data set which contains anomalies and/or faults. In a real-world operational deployment of a BESS solution, the various subsystem of the BESS may not perform as expected. During data set and correlation matrix preparation any anomalies or faults are defined as parameters to the correlation matrix 400. These anomaly and/or fault parameters are input to the anomaly/fault model as input. The anomaly/fault model is trained on these anomalies apart from the general correlation between the parameters. During training, a binary cross entropy loss for the anomaly/fault is added for each featured anomaly/fault. The additional features that represent anomaly are shown below.

The generator for the anomaly/fault model can be represented as:

$$yg = G(z,x,a),$$

where a = the feature indicating the presence of anomalies.

The discriminator for the anomaly/fault model can be represented as:
D(y,x,a) ---> [0,1] and D(yg, x,a) ---> [0,1] where the discriminator's output is a function of both the real and generated data, including the anomalies and any input faults.

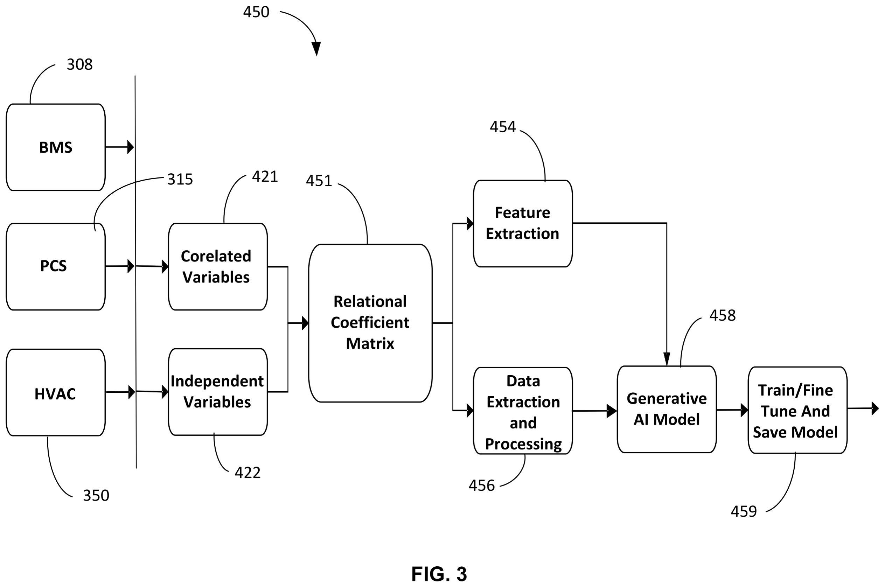

Each BESS model includes a different relational coefficient matrix. For example, in FIG. 3 a data set for a relational coefficient matrix 450 for one of the three models, e.g., factory, calibration, anomaly/fault, is shown. The model is prepared with correlational features of the BESS solution subsystems from real-world data input from operational BESS solutions in the field. In the data set preparation, a feature algorithm is created with each row of the matrix corresponding to a time sequence data sample of the parameters/feature of the BESS subsystem. Each column in the matrix corresponds to a parameter or a feature. Each data point has timestamp and a corresponding numerical value. This feature algorithm may also include a statistical feature (such as mean, variance), time based (hours, rates), lagged values, charge/discharge, etc. as general features based on BESS solution subsystems.

The combined relational matrix 451 is used to create features that capture relationship between correlated 421 and independent variable 422 parameters across the BESS subsystems. In the combined matrix 451 features are input based on the model architecture. For example, as was explained above for the correlation model and the anomaly/fault model calibration and anomaly/fault features are added as parameters to matrix 451.

A features algorithm is created with each row of matrix 451 corresponding to a time sequence data sample of the dependent parameters of the BESS subsystem. Each column in matrix 451 corresponds to an independent parameter or a feature. Correlated features 454 and the data set correlations 456 are separately extracted from the matrix 451 and input to a generative AI model 458. The generative AI model 458 along with training data is used to build model 459, e.g., factory, calibration, anomaly/fault, and the model saved.

Each of the models of the BESS architecture consists of a generative adversarial (GAN) network with a recurrent neural network (RNN) layer of a long short-term memory (LSTM) to allow the model to handle sequential timeseries data. The input layer of the GAN generator accepts sequences of features from the relational correlation matrix 450 and the features of correlation matrix 451 including both dependent and independent parameters/variables. The LSTM layers encode temporal dependencies and patterns in the input sequences based on the relational matrix 450 and feature matrix 451. In the decoder of the generator, the LSTM layer decodes the information and generates sequences for each parameter whether it is dependent or independent. The correlation matrix 450 is applied to decode the sequences.

In the output layer of the generator the sequences are passed to the discriminator for each subsystem of the BESS. The discriminator accepts the generated sequential data from the LSTM layer of the generator and real sequences from the BESS training data sets. These input sequences will be processed and learn to discriminate between real and generated BESS subsystem data. The output layer of the discriminator performs a binary classification on the data indicating if the input is real or generated. During model training, the LSTM based generator and discriminator are trained simultaneously. The discriminator is trained first on a real BESS data set and generated data and then the generator is trained on the combined model. For the loss functions in the model, the generator is fine tuned to produce the sequences that are difficult for the discriminator to distinguish from real data training data. Also, additional losses are included such as mean square errors to ensure generated sequences match the real sequences closely. In the discriminator loss function, the cross entropy classifies the data sequences as real or generated.

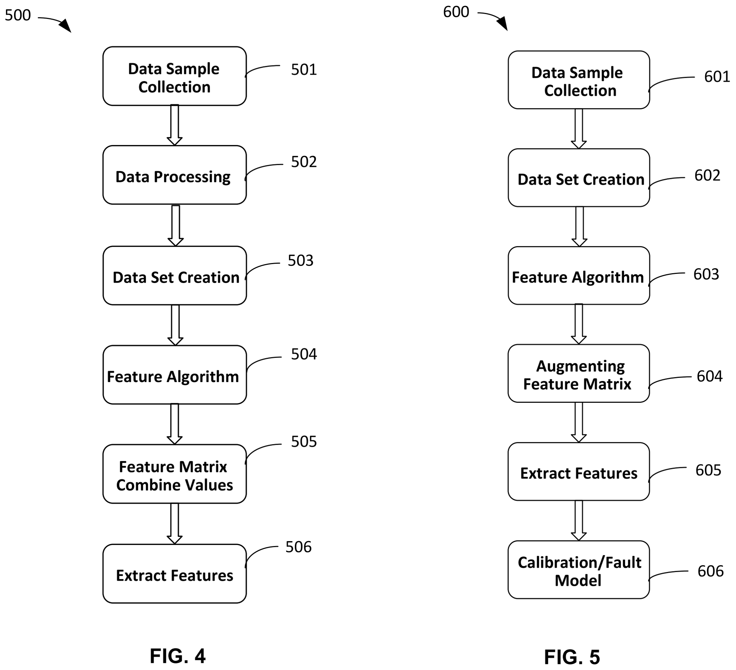

FIG. 4 illustrates a block diagram 500 of a first embodiment for a method for collecting and extracting the features of a BESS for the purposes of training the BESS models. In step 501, data is collected from the BESS containers 120 deployed and used in the field. Next, in step 502 the collected data is processed to account for missing values, scale, or to normalize the data set and a data set created in step 503 with the processed data. In step 504 a features algorithm is applied to the created data set that adds statistical features (i.e., mean, variance), time-based (hours, rates), and/or lagged feature parameters for each of the BESS subsystems. In step 505 a combined relational matrix is developed that combines the values from the data set. Each row of the combined relational matrix represents a time step, and each column represents a feature that creates a relational matrix of features that capture the relationships between parameters entered from the data set and which are extracted from the relational matrix in step 506.

FIG. 5 illustrates a block diagram 600 of an exemplary second embodiment of a method for collecting and extracting features of a BESS which includes calibration and anomaly/fault parameters as additional features for training the BESS models. In step 601, data is collected from the BESS containers 120 deployed and used in the field. Next, in step 602 time series data is labeled and distinguished between periods of time when the BESS is in the normal factory mode, i.e., without defects and periods when there are defects. Next, in step 603 a features algorithm adds statistical (mean, variance), or time based (hours, rates) features to the data set. The features from step 603 are combined in a relational matrix in step 604 that joins values from the other subsystems of the BESS. Each row of the combined relational matrix represents a time step, and each column represents a feature. This augments the relational matrix and creates a matrix of features that capture the relationships between parameters that include calibration and anomaly/fault parameters. The features identified in step 604 are extracted from the relational matrix in step 605 and applied to a calibration anomaly/fault model in step 606.

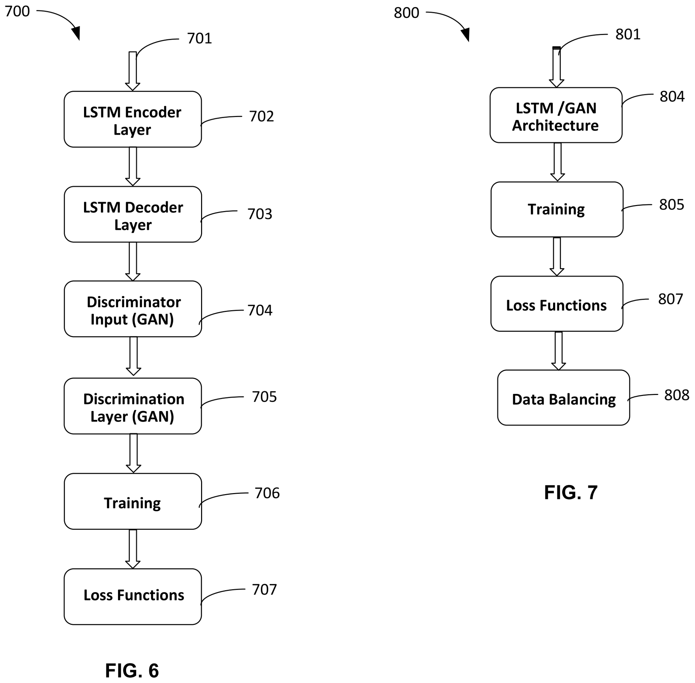

FIG. 6 illustrates a block diagram 700 of the common model architecture of the BESS. The BESS common model 700 consists of a generative adversarial (GAN) network with a recurrent neural network (RNN) layer of a long short-term memory (LSTM) to allow the model to manage sequential data. The common model has ideal subsystem behavior where the data from each subsystem includes relational as well as independent parameters that do not degrade during the operation of the BESS. This common model is also known in this disclosure as the factory model representing a factory generated BESS system which may or may not have any anomaly in the parameters of its correlation matrix. The common/factory model represents the ideal behavior of the BESS. The relationships between parameters extracted from the relational matrix of step 506 of FIG. 4 are input via 701 to step 702 of the common model architecture.

The common model 700 generator uses an LSTM encoder layer in step 702 that accepts input sequences of features, including both dependent and independent parameters, which encodes temporal dependencies and patterns in the input sequences based on the relational matrix 450 and feature matrix 451. The generator LSTM decoder layer in step 703 decodes the input sequences and generates output sequences for each parameter whether it is dependent or independent for each parameter.

The output from step 703 is next applied in step 704 to a GAN discriminator input layer. The input layer accepts generated sequences from the LSTM and real sequences from the training data. In step 705 a GAN discrimination layer process the input sequences from the GAN input layer to learn to discriminate between real and generated sequences. The input sequences are processed to learn to discriminate between real and generated BESS subsystem data. The output layer of the discriminator performs a binary classification on the data indicating if the input is real or is generated. Next in step 706 the model is trained with the training data. The LSTM encoder and decoder steps 702, 703 of the generator and the GAN discriminator of steps 704, 705 are trained simultaneously, alternating the training of the LSTM generator and GAN discriminator in alternating steps.

The model is further tuned by loss functions in step 707. The loss functions in step 707 includes a generator loss consisting of adversarial loss that tunes the loss function of generator to produce sequences that are difficult for the discriminator to distinguish from real data. Additional loss is included such as mean squared error (MSE) to ensure generated sequences match real sequences closely. Loss functions of step 707 also may include discriminator loss providing a binary cross entropy loss that classifies sequences as real or generated.

FIG. 7 illustrates a block diagram 800 for the calibration and anomaly/fault model architecture. The feature relationships between parameters extracted from step 606 of FIG. 5 are input to model 800 via input 801. The input sequences with calibration and anomaly/fault sequences are processed by step 804 with a LSTM/GAN architecture similar to steps 702-705 of the common model 700. However, the LSTM/GAN architecture of step 804 has the LSTM modified with an attention mechanism. The attention mechanism allows a focus away from the common parts of the input feature sequences to give more emphasis to the time series data of the defect periods entered in step 602 of FIG. 5.

The LSTM/GAN architecture 804 generates sequences from the LSTM layer and real sequences from the training data and the GAN discrimination process. The input sequences from the GAN input layer learn to discriminate between real and generated sequences, however with the focus to calibration and anomaly/faults and processed to learn to discriminate between real and generated BESS subsystem data. The output layer of the GAN discriminator performs a binary classification on the data indicating if the input is real or is generated. Next step 805, the calibration, and anomaly/-fault model 800 is trained with the training data. As with the common model 700, the LSTM encoder and decoder of the generator and the GAN discriminator of the LSTM/GAN Architecture 804 of model 800 are trained simultaneously, alternating the training of the LSTM and GAN discriminator in alternating steps.

The calibration and anomaly/fault model 800 is further tuned by loss functions in step 807. The loss functions in step 807 that include a generator loss consisting of an adversarial loss that tunes the loss function of the generator to produce sequences that are difficult for the discriminator to distinguish from real data. Additional loss is included such as mean squared error (MSE) to ensure generated sequences match real sequences closely. The loss functions of step 807 further include discriminator loss consisting of a binary cross entropy loss that classifies sequences as real or generated and a binary cross entropy loss for the calibration and anomaly/fault classification added for each calibration and anomaly/fault parameter.

In step 808 data balancing is done for any imbalanced data (e.g., fewer instances with defects or additional feature) to adjust class weights to prevent bias.

It may be advantageous to set forth definitions of certain words and phrases used throughout this patent document. The term "communicate," as well as derivatives thereof, encompasses both direct and indirect communication. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present application should not be read as implying that any particular element, step, or function is an essential or critical element that must be included in the claim scope. The scope of patented subject matter is defined only by the allowed claims. Moreover, none of the claims is intended to invoke 35 U.S.C. § 112(f) with respect to any of the appended claims or claim elements unless the exact words "means for" or "step for" are explicitly used in the particular claim, followed by a participle phrase identifying a function. Use of terms such as (but not limited to) "mechanism," "module," "device," "unit," "component," "element," "member," "apparatus," "machine," "system," or "controller" within a claim is understood and intended to refer to structures known to those skilled in the relevant art, as further modified or enhanced by the features of the claims themselves and is not intended to invoke 35 U.S.C. § 112(f).

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A method for generating real-world data for monitoring and analyzing the operation of a battery energy storage system (BESS) comprises:

    entering data parameters from one or more subsystems of a field installed BESS into a correlation matrix;
    extracting a target correlation from the correlation matrix and entering the target correlations and independent data parameters into a relational coefficient matrix to identify data features;
    extracting the data features from the relational coefficient matrix to an artificial intelligence network model;
    training the artificial intelligence network model with data from the field installed BESS solution; and
    deploying the artificial intelligence network model to monitor and analyze the operation of the BESS.

2. The method of claim 1, wherein the data parameters comprise dependent parameters that rely on or are related to the subsystem operating in the BESS

3. The method of claim 2, wherein extracting a target correlation comprises identifying a range of moderate to strong correlations between the parameters mapped in the correlation matrix.

4. The method of claim 1, wherein extracting data features comprises using a features algorithm to

**EP 4 749 885 A1**

capture relationships between the corelated variables from the correlation matrix and independent parameters from the BESS subsystems.

5. The method of claim 4, wherein each row of the correlation matrix corresponds to a time sequence data sample of the dependent parameters.

6. The method of claim 4, wherein each column of the correlation matrix corresponds to an independent parameter or feature.

7. The method of claim 6, wherein the data set of the correlation matrix is input to the artificial intelligence network model along with the data features.

8. The method of claim 4, wherein the artificial intelligence network model is a common model that has ideal subsystem behavior, wherein the independent data parameters do not degrade in the performance of the BESS.

9. The method of claim 4, wherein the artificial intelligence network model is a calibration model, wherein the independent data parameters from the BESS include parameters pertaining to the state of charge (SOC) of battery cells of the BESS.

10. The method of claim 4, wherein the artificial intelligence network model is an anomaly/fault model, wherein the data from the BESS includes data parameters that contain anomalies or faults in one or more subsystems that occurred during the operation of the BESS.

FIG. 1

| | | BMS | | | | | | | | | PCS | | | HVAC |
|---|---|---|---|---|---|---|---|---|---|---|---|---|---|---|
| | | Cell_Volt | Cell_Temp | Input_Volt | Rack_Current | Rack_SOC | Rack_Volt | Total_Volt | Total_Current | Active_Poweref | System_SOC | Active_Power | Grid_Freq | HVAC_TEMP |
| BMS | Cell_Volt | 1 | 0.90807476 | -0.19668633 | 0.00151972 | 0.27844438 | 0.3825649 | -0.06083118 | -0.00133191 | 0.00168497 | 0.04211472 | 0.039744816 | -0.20909961 | -0.10068319 |
| | Cell_Temp | 0.90807476 | 1 | 0.01118805 | -0.00575876 | 0.29218175 | 0.35450401 | 0.11732461 | -0.01004742 | 0.020281071 | 0.2154805 | 0.066003138 | -0.02425311 | 0.01397828 |
| | Input_Volt | -0.19668633 | 0.01118805 | 1 | -0.070424 | 0.14137515 | -0.18685512 | 0.71322747 | -0.06978863 | -0.057041194 | 0.67613436 | 0.047253622 | 0.67345614 | 0.42006143 |
| | Rack_Current | 0.00151972 | -0.00575876 | -0.070424 | 1 | -0.0611239 | -0.03805828 | -0.08486566 | 0.983218036 | 0.438847388 | -0.06176896 | 0.637504912 | -0.04508655 | -0.03894321 |
| | Rack_SOC | 0.27844438 | 0.29218175 | 0.14137515 | -0.0611239 | 1 | 0.57083652 | 0.2836557 | -0.05180036 | -0.050273929 | 0.38452084 | -0.02058502 | -0.02704634 | 0.05404116 |
| | Rack_Volt | 0.3825649 | 0.35450401 | -0.18685512 | -0.03805828 | 0.57083652 | 1 | 0.13829658 | -0.02128421 | -0.038528139 | 0.21767651 | -0.01360747 | -0.17445104 | 0.11049141 |
| | Total_Volt | -0.06083118 | 0.11732461 | 0.71322747 | -0.08486566 | 0.2836557 | 0.13829658 | 1 | -0.08471365 | -0.061515119 | 0.75352148 | 0.052627673 | 0.59768033 | 0.37854012 |
| | Total_Current | -0.00133191 | -0.01004742 | -0.06978863 | 0.98321804 | -0.05180036 | -0.02128421 | -0.08471365 | 1 | 0.459418782 | -0.0604018 | 0.651607421 | -0.04429025 | -0.03911291 |
| | System_SOC | 0.04211472 | 0.2154805 | 0.67613436 | -0.06176896 | 0.38452084 | 0.21767651 | 0.75352148 | -0.0604018 | -0.054500923 | 1 | 0.034136943 | 0.39547508 | 0.35200683 |
| PCS | Active_Poweref | 0.00168497 | 0.02028107 | -0.05704119 | 0.43884739 | -0.05027393 | -0.03852814 | -0.06151512 | 0.459418782 | 1 | -0.05450092 | 0.721607995 | -0.03448017 | -0.01494598 |
| | Active_Power | 0.03974482 | 0.06600314 | 0.04725362 | 0.63750491 | -0.02058502 | -0.01360747 | 0.05262767 | 0.651607421 | 0.721607995 | 0.03413694 | 1 | 0.03964342 | 0.0121735 |
| | Grid_Freq | -0.20909961 | -0.02425311 | 0.67345614 | -0.04508655 | -0.02704634 | -0.17445104 | 0.59768033 | -0.04429025 | -0.034480173 | 0.39547508 | 0.039643422 | 1 | 0.36527106 |
| HVAC | Container_TEMP | -0.10068319 | 0.01397828 | 0.42006143 | -0.03894321 | 0.05404116 | 0.11049141 | 0.37854012 | -0.03911291 | -0.014945981 | 0.35200683 | 0.012173503 | 0.36527106 | 1 |

400 410 401 413 402 403 414 405 406 407 412

**FIG. 2**

**FIG. 3**

BMS 308

PCS 315

HVAC 350

Corelated Variables 421

Independent Variables 422

Relational Coefficient Matrix 451

450

Feature Extraction 454

Data Extraction and Processing 456

Generative AI Model 458

Train/Fine Tune And Save Model 459

**FIG. 5**

600

| Data Sample Collection | 601 |
| Data Set Creation | 602 |
| Feature Algorithm | 603 |
| Augmenting Feature Matrix | 604 |
| Extract Features | 605 |
| Calibration/Fault Model | 606 |

**FIG. 4**

500

| Data Sample Collection | 501 |
| Data Processing | 502 |
| Data Set Creation | 503 |
| Feature Algorithm | 504 |
| Feature Matrix Combine Values | 505 |
| Extract Features | 506 |

700

701

```
         ┌──────────────────┐
         │  LSTM Encoder    │ ─── 702
         │     Layer        │
         └──────────────────┘
                 │
                 ▼
         ┌──────────────────┐
         │  LSTM Decoder    │ ─── 703
         │     Layer        │
         └──────────────────┘
                 │
                 ▼
         ┌──────────────────┐
         │  Discriminator   │ ─── 704
         │   Input (GAN)    │
         └──────────────────┘
                 │
                 ▼
         ┌──────────────────┐
         │  Discrimination  │ ─── 705
         │   Layer (GAN)    │
         └──────────────────┘
                 │
                 ▼
         ┌──────────────────┐
         │    Training      │ ─── 706
         └──────────────────┘
                 │
                 ▼
         ┌──────────────────┐
         │  Loss Functions  │ ─── 707
         └──────────────────┘
```

**FIG. 6**

800

801

```
         ┌──────────────────┐
         │   LSTM /GAN      │ ─── 804
         │  Architecture    │
         └──────────────────┘
                 │
                 ▼
         ┌──────────────────┐
         │    Training      │ ─── 805
         └──────────────────┘
                 │
                 ▼
         ┌──────────────────┐
         │  Loss Functions  │ ─── 807
         └──────────────────┘
                 │
                 ▼
         ┌──────────────────┐
         │  Data Balancing  │ ─── 808
         └──────────────────┘
```

**FIG. 7**

14

Europäisches
Patentamt

European
Patent Office

Office européen
des brevets

# EUROPEAN SEARCH REPORT

**Application Number**

EP 25 21 6387

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TAMEEMI ALI QAHTAN: "Reliable Battery Terminal Voltage Collapse Detection Using Supervised Machine Learning Approaches", IEEE SENSORS JOURNAL, IEEE, vol. 22, no. 1, 30 November 2021 (2021-11-30), pages 795-802, XP011896275, ISSN: 1530-437X, DOI: 10.1109/JSEN.2021.3131859 [retrieved on 2021-12-28] * absract; page 3 -labelled 797-, right column, first paragraph * ----- | 1-10 | INV. H02J7/80 G01R31/367 G01R31/392 G06N3/08 G06N20/00 |

**TECHNICAL FIELDS SEARCHED (IPC)**

G06N
H02J
H01M
B60L

The present search report has been drawn up for all claims

| Place of search | Date of completion of the search | Examiner |
|---|---|---|
| Munich | 24 February 2026 | Varela Fraile, Pablo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)